# EUROPEAN PATENT APPLICATION

(11) **EP 4 550 962 A1**
(43) Date of publication of application: **07.05.2025**
(21) Application number: 24183288.0
(22) Date of filing: 20.06.2024
(51) Int. Cl.: H10B 12/00, H01L 21/02, H01L 29/786

(54) **SEMICONDUCTOR DEVICE**

(30) Priority: 03.11.2023 KR 20230150975
(71) Applicant: Samsung Electronics Co., Ltd., Suwon-si, Gyeonggi-do 16677 (KR)
(72) Inventor: KIM, Jinbum, 16677 Suwon-si, Gyeonggi-do (KR); NAM, Dae-Jin, 16677 Suwon-si, Gyeonggi-do (KR); PARK, Hyojin, 16677 Suwon-si, Gyeonggi-do (KR); SON, Soomin, 16677 Suwon-si, Gyeonggi-do (KR); YANG, Guifu, 16677 Suwon-si, Gyeonggi-do (KR); LEE, Kyeonggyu, 16677 Suwon-si, Gyeonggi-do (KR); ZOH, Inhae, 16677 Suwon-si, Gyeonggi-do (KR)
(74) Representative: Kuhnen & Wacker Patent- und Rechtsanwaltsbüro PartG mbB

(57) **Abstract**

Disclosed is a semiconductor device comprising a substrate that includes a device isolation pattern and an active region, a bit line that extends in a first direction on the substrate, a semiconductor pattern on the bit line, a growth mask layer on the bit line and having a sidewall in contact with the semiconductor pattern, a word line on the bit line and extending in a second direction that intersects the first direction, and a gate dielectric pattern between the word line and the semiconductor pattern. A top surface of the growth mask layer is at a level higher than that of a bottom surface of the semiconductor pattern.

## Description

### CROSS-REFERENCE TO RELATED APPLICATION

This U.S. nonprovisional application claims priority under 35 U.S.C § 119 to Korean Patent Application No. 10-2023-0150975, filed on November 3, 2023, in the Korean Intellectual Property Office, the disclosure of which is hereby incorporated by reference in its entirety.

### BACKGROUND

The present inventive concepts relate to a semiconductor device, and more particularly, to a semiconductor device including vertical channel transistors and a method of fabricating the same.

A reduction in design rule of semiconductor devices induces development of fabrication technology to increase integration, operating speeds, and manufacturing yield of semiconductor devices. Accordingly, transistors with vertical channels have been suggested to increase their integration, resistance, current driving capability, and so forth.

### SUMMARY

Some embodiments of the present inventive concepts provide a semiconductor device with improved electrical properties and increased reliability.

An object of the present inventive concepts is not limited to the mentioned above, and other objects which have not been mentioned above will be clearly understood to those skilled in the art from the following description.

According to some embodiments of the present inventive concepts, a semiconductor device may comprise: a substrate that includes a device isolation pattern and an active region; a bit line that extends in a first direction on the substrate; a semiconductor pattern on the bit line; a growth mask layer on the bit line, a sidewall of the growth mask layer being in contact with the semiconductor pattern; a word line on the bit line, the word line extending in a second direction that intersects the first direction; and a gate dielectric pattern between the word line and the semiconductor pattern. A top surface of the growth mask layer may be at a level higher than a level of a bottom surface of the semiconductor pattern.

According to some embodiments of the present inventive concepts, a semiconductor device may comprise: a substrate that includes a device isolation pattern and an active region; a bit line that extends in a first direction on the substrate; a semiconductor pattern on the bit line; a growth mask layer on the bit line; a word line on the bit line, the word line extending in a second direction that intersects the first direction; and a gate dielectric pattern between the word line and the semiconductor pattern. A sidewall of the semiconductor pattern may be in contact with the gate dielectric pattern and a sidewall of the growth mask layer.

According to some embodiments of the present inventive concepts, a semiconductor device may comprise: a substrate that includes a device isolation pattern and an active region; a cell array structure on the substrate; a peripheral circuit structure on the substrate and adjacent to the cell array structure in a first direction parallel to an extending direction of the substrate, the peripheral circuit structure including a peripheral gate structure and a peripheral contact pad; a bit line in the cell array structure, the bit line extending in the first direction; a semiconductor pattern on the bit line; a growth mask layer on the bit line, a sidewall of the growth mask layer being in contact with the semiconductor pattern; a first word line and a second word line on the bit line, the first and second word lines extending in a second direction that intersects the first direction; a gate dielectric pattern between the first word line and the semiconductor pattern; a contact pattern on the semiconductor pattern; and a landing pad on the contact pattern. A top surface of the landing pad may be at a level the same as a level of a top surface of the peripheral contact pad. A bottom surface of the peripheral gate structure may be at a level the same as a level of a bottom surface of the bit line. A top surface of the growth mask layer may be at a level higher than a level of a bottom surface of the semiconductor pattern.

### BRIEF DESCRIPTION OF DRAWINGS

FIG. 1 illustrates a block diagram showing a semiconductor device according to example embodiments of the present inventive concepts.
FIG. 2 illustrates a simplified perspective view showing a semiconductor device according to example embodiments of the present inventive concepts.
FIG. 3 illustrates a plan view showing a semiconductor device according to example embodiments of the present inventive concepts.
FIGS. 4 and 5 illustrate cross-sectional views respectively taken along lines A-A' and B-B' of FIG. 3.
FIG. 6 illustrates a cross-sectional view showing a semiconductor device according to example embodiments of the present inventive concepts.
FIG. 7 illustrates a cross-sectional view taken along line B-B' of FIG. 3, showing a semiconductor device according to example embodiments of the present inventive concepts.
FIG. 8 illustrates a cross-sectional view taken along line B-B' of FIG. 3, showing a semiconductor device according to example embodiments of the present inventive concepts.
FIGS. 9A to 13A illustrate plan views showing a method of fabricating a semiconductor device according to example embodiments of the present inventive concepts.
FIGS. 9B to 13B illustrate cross-sectional views taken along line A-A' of FIG. 3, showing a method of fabricating a semiconductor device according to example embodiments of the present inventive concepts.
FIGS. 9C to 13C illustrate cross-sectional views taken along line B-B' of FIG. 3, showing a method of fabricating a semiconductor device according to example embodiments of the present inventive concepts.
FIGS. 14A to 14C illustrate cross-sectional views showing a method of fabricating a semiconductor device according to the example embodiment of FIG. 8.

### DETAILED DESCRIPTION OF EMBODIMENTS

It will be hereinafter discussed a semiconductor device and a method of fabricating the same according to some embodiments of the present inventive concepts in conjunction with the accompanying drawings. Like reference characters refer to like elements throughout.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

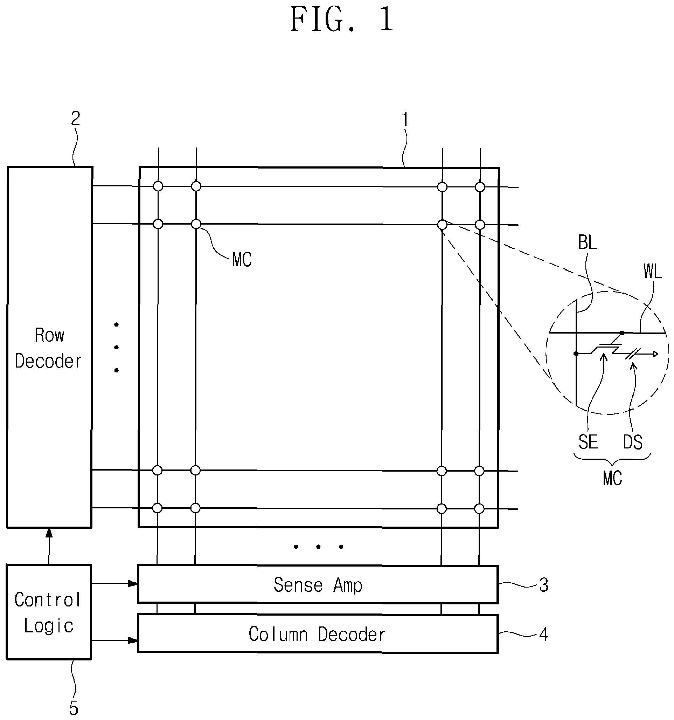

FIG. 1 illustrates a block diagram showing a semiconductor device according to example embodiments of the present inventive concepts.

Referring to FIG. 1, a semiconductor device may include a memory cell array 1, a row decoder 2, a sense amplifier 3, a column decoder 4, and a control logic 5.

The memory cell array 1 may include a plurality of memory cells MC that are arranged two-dimensionally or three-dimensionally. Each of the memory cells MC may be connected between a word line WL and a bit line BL that cross each other.

Each of the memory cells MC may include a selection element SE and a data storage element DS, and the selection element SE and the data storage element DS may be electrically in series. The selection element SE may be connected between the data storage element DS and the word line WL, and the data storage element DS may be connected through the selection element SE to the bit line BL. The selection element SE may be a field effect transistor (FET), and the data storage element DS may be a capacitor, a magnetic tunnel junction pattern, or a variable resistor. For example, the selection element SE may include a transistor whose gate electrode is connected to the word line WL and whose source/drain terminals are connected to the bit line BL and the data storage element DS.

The row decoder 2 may decode an address input from external and select one of the word lines WL of the memory cell array 1. The address that is decoded in the row decoder 2 may be provided to a row driver (not shown), and in response to a control operation of control circuits, the row driver may provide a certain voltage to a selected word line WL and each of non-selected word lines WL.

In response to an address decoded from the column decoder 4, the sense amplifier 3 may detect and amplify a voltage difference between a selected bit line BL and a reference bit line, and may then output the amplified voltage difference.

The column decoder 4 may provide a data delivery pathway between the sense amplifier 3 and an external device (e.g., a memory controller). The column decoder 4 may decode an address input from an external and select one of the bit lines.

The control logic 5 may generate control signals that control operations to write data to the memory cell array 1 and/or to read data from the memory cell array 1.

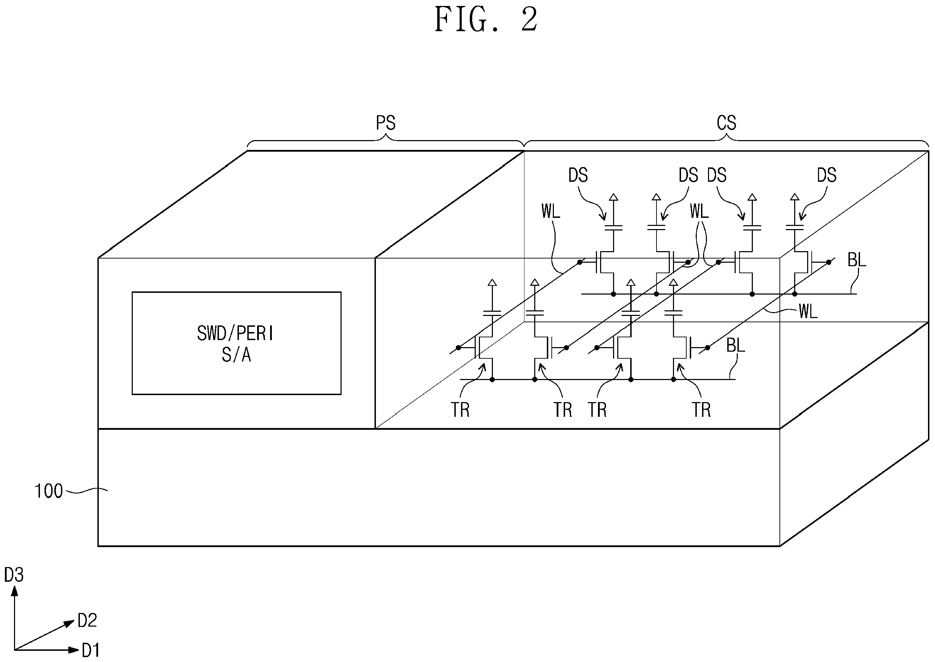

FIG. 2 illustrates a simplified perspective view showing a semiconductor device according to example embodiments of the present inventive concepts.

Referring to FIG. 2, a semiconductor device according to some embodiments of the present inventive concepts may include a peripheral circuit structure PS on a substrate 100, and may also include a cell array structure CS on the substrate 100, such that the cell array structure CS neighbors the peripheral circuit structure PS in a direction parallel to the substrate 100.

The peripheral circuit structure PS may include core/peripheral circuits formed on the substrate 100. The core/peripheral circuits may include the row and column decoders (see, e.g., row decoder 2 and column decoder 4 of FIG. 1), the sense amplifier (see, e.g., sense amplifier 3 of FIG. 1), and the control logic (see, e.g., control logic 5 of FIG. 1). The peripheral circuit structure PS may be provided on the substrate 100 in a third direction D3 perpendicular to a top surface of the substrate 100.

The cell array structure CS may include bit lines BL, word lines WL, and memory cells (see, e.g., memory cells MC of FIG. 1) between the bit lines BL and the word lines WL. The memory cells (see, e.g., memory cells MC of FIG. 1) may be two-dimensionally or three-dimensionally arranged on a plane that extends in first and second directions D1 and D2 that intersect each other and are parallel to the top surface of the substrate 100. Each of the memory cells (see, e.g., memory cells MC of FIG. 1) may include, as discussed above, a selection element SE and a data storage element DS.

According to some embodiments, a vertical channel transistor (VCT) TR may be included as the selection element SE of each memory cell (see, e.g., memory cells MC of FIG. 1). The vertical channel transistor TR may indicate a structure whose channel length extends in a direction (e.g., the third direction D3) perpendicular to the top surface of the substrate 100. In addition, each memory cell (see, e.g., memory cells MC of FIG. 1) may include a capacitor as the data storage element DS.

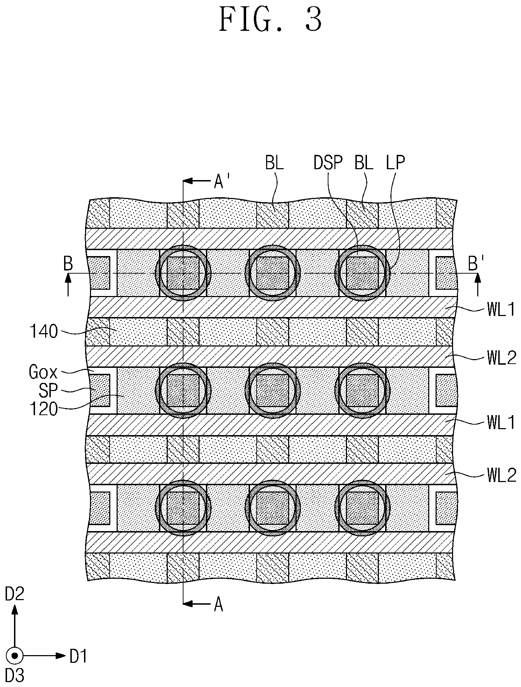

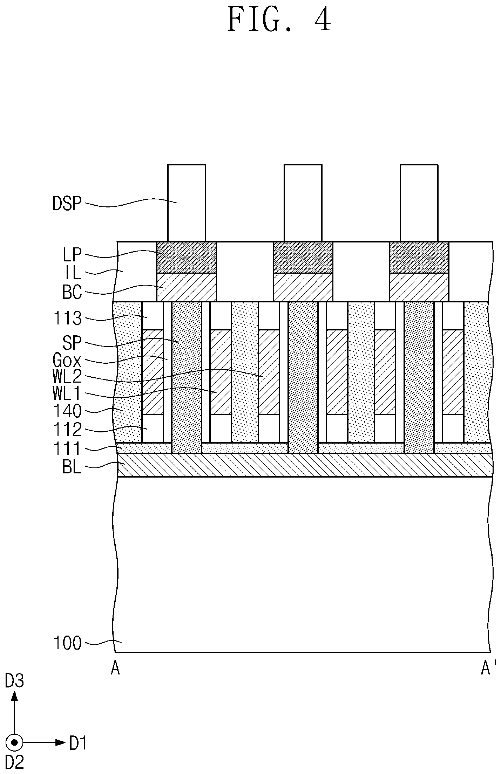

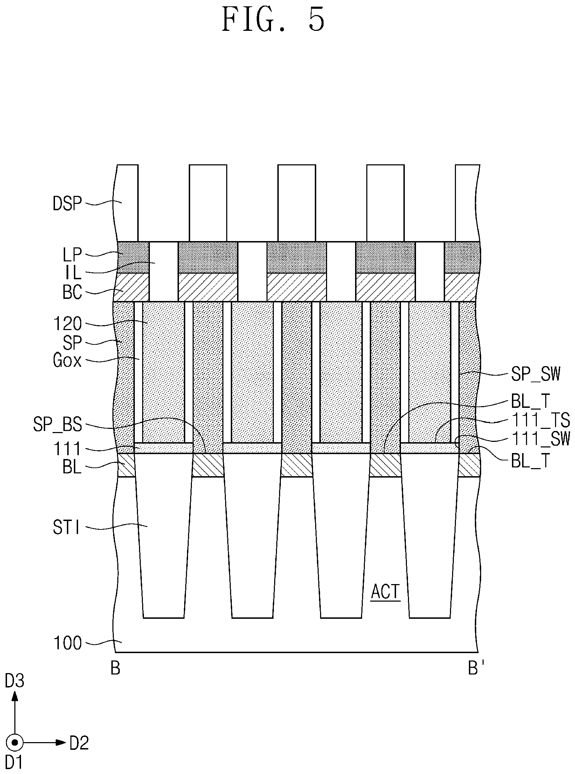

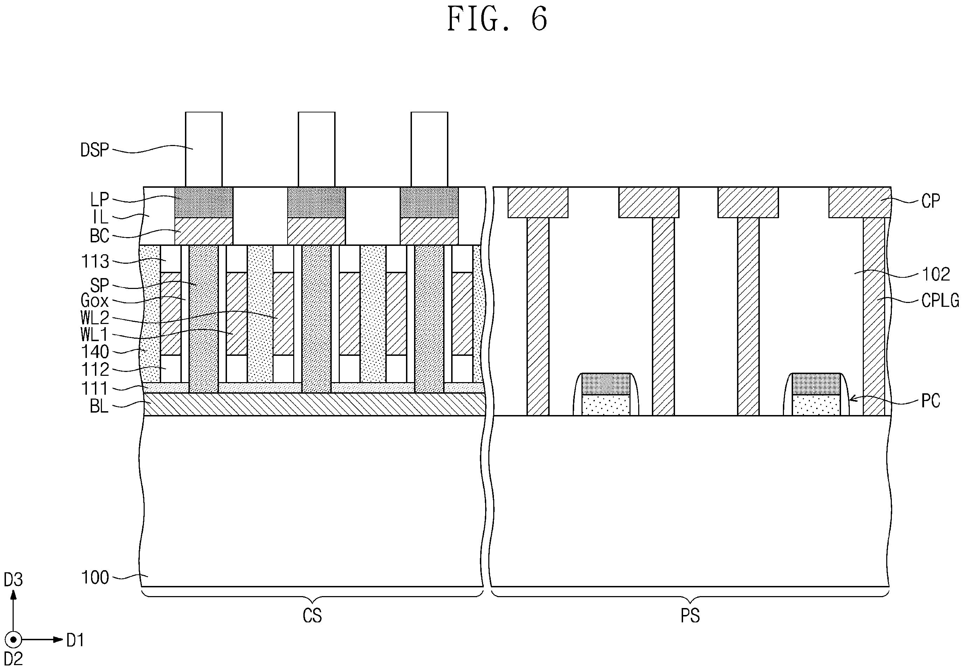

FIG. 3 illustrates a plan view showing a semiconductor device according to example embodiments of the present inventive concepts. FIGS. 4 and 5 illustrate cross-sectional views respectively taken along lines A-A' and B-B' of FIG. 3. FIG. 6 illustrates a cross-sectional view showing a semiconductor device according to example embodiments of the present inventive concepts.

Referring to FIGS. 3 to 6, a semiconductor device according to some embodiments of the present inventive concepts may include a substrate 100, a peripheral circuit structure PS on the substrate 100, and a cell array structure CS adjacent in a first direction D1 to the peripheral circuit structure PS.

The substrate 100 may be a semiconductor substrate. The substrate 100 may be, for example, a silicon substrate, a germanium substrate, or a silicon-germanium substrate.

The peripheral circuit structure PS may include a peripheral gate structure PC integrated on the substrate 100, peripheral contact pads CP, peripheral contact plugs CPLG, and a peripheral interlayer dielectric layer 102 that covers the peripheral gate structure PC, the peripheral contact pads CP, and the peripheral contact plugs CPLG. The peripheral gate structure PC may contact the substrate 100. The peripheral contact plugs CPLG may contact an upper surface of the substrate 100, the peripheral contact pads CP may contact an upper surface of the peripheral contact plugs CPLG. The peripheral gate structure PC may include the sense amplifier 3 of FIG. 1.

The cell array structure CS may include memory cells including a vertical channel transistor. The cell array structure CS may include a bit line BL, a growth mask layer 111 on the bit line BL, a semiconductor pattern SP on the bit line BL, a plurality of lower gate capping patterns 112 on the growth mask layer 111, a first word line WL1 and a second word line WL2 on the lower gate capping pattern 112, an upper gate capping pattern 113 on the first word line WL1 and the second word line WL2, a first dielectric pattern 140 and a second dielectric pattern 120 on the growth mask layer 111, a gate dielectric pattern Gox in contact with the semiconductor pattern SP, a contact pattern BC on the semiconductor pattern SP, a landing pad LP on the contact pattern BC, and a data storage pattern DSP on the landing pad LP. In example embodiments, the growth mask layer 111 and the semiconductor pattern SP may contact an upper surface of the bit line BL, the plurality of lower gate capping patterns 112 may contact an upper surface of the growth mask layer 111, the first and second word lines WL1 and WL2 may contact an upper surface of the lower gate capping pattern 112, the upper gate capping pattern 113 may contact upper surfaces of the first and second word lines WL1 and WL2, the first dielectric pattern 140 and the second dielectric pattern 120 may contact an upper surface of the growth mask layer 111, the contact pattern BC may contact upper surfaces of the semiconductor pattern SP, the upper gate capping pattern 113, and the gate dielectric pattern Gox, the landing pad LP may contact an upper surface of the contact pattern BC, and the data storage pattern DSP may contact an upper surface of the landing pad LP. Upper surfaces of the first dielectric pattern 140, the upper gate capping pattern 113, the gate dielectric pattern Gox, and the semiconductor pattern SP may be coplanar with one another.

The peripheral gate structure PC of the peripheral circuit structure PS may be electrically connected to the cell array structure CS through the peripheral contact plug CPLG and the peripheral contact pad CP. The peripheral interlayer dielectric layer 102 may include a plurality of stacked dielectric layers including, for example, at least one selected from silicon oxide, silicon nitride, silicon oxynitride, and low-k dielectrics.

The bit line BL may be provided on the substrate 100 while extending lengthwise in the first direction D1. The bit line BL may be provided in plural, and the plurality of bit lines BL may be spaced apart from each other in a second direction D2.

The bit line BL may, for example, include doped polysilicon. The bit line BL may include phosphorus (P). The bit line BL may include phosphasilene. The bit line BL may include at least one selected from conductive metal silicide and metal, such as Al, Cu, Ti, Ta, Ru, W, Mo, Pt, Ni, and Co.

The substrate 100 may include an active region ACT and a device isolation pattern STI. The active region ACT and the device isolation pattern STI may be provided in the substrate 100. The device isolation pattern STI may define the active regions ACT. The active regions ACT may extend lengthwise in the first direction D1. The active regions ACT may be defined to refer to upper portions of the substrate 100 that protrude in a third direction D3. The active regions ACT may be spaced apart from each other. The device isolation pattern STI may be provided between the active regions ACT. The device isolation pattern STI may include a dielectric material. For example, the device isolation pattern STI may include oxide. The device isolation pattern STI may separate the bit lines BL from each other in the second direction D2.

A top surface of the device isolation pattern STI may be coplanar with a top surface BL_T of the bit line BL. The top surface of the device isolation pattern STI may be located at the same level as that of the top surface BL_T of the bit line BL.

The growth mask layer 111 and the semiconductor pattern SP may be provided on the bit line BL. The semiconductor pattern SP may be provided on the top surface BL_T of the bit line BL on which the growth mask layer 111 is not provided. The growth mask layer 111 may be provided on the device isolation pattern STI. The top surface of the device isolation pattern STI may be in contact with the growth mask layer 111. The device isolation pattern STI and the growth mask layer 111 may overlap each other. The device isolation pattern STI and the semiconductor pattern SP may not overlap each other. The growth mask layer 111 and the semiconductor pattern SP may not overlap each other.

The semiconductor pattern SP may be provided in plural. The plurality of semiconductor patterns SP may be spaced apart from each other in the first and second directions D1 and D2.

A bottom surface SP_BS of the semiconductor pattern SP may be in contact with the top surface BL_T of the bit line BL. The semiconductor pattern SP may extend in the third direction D3 from the bit line BL. A sidewall 111_SW of the growth mask layer 111 may be in contact with a sidewall SP_SW of the semiconductor pattern SP. A top surface 111_TS of the growth mask layer 111 may be located at a higher level than that of the bottom surface SP_BS of the semiconductor pattern SP.

The semiconductor pattern SP may include silicon. The semiconductor pattern SP may include a crystalline material. The semiconductor pattern SP may include doped silicon. For example, the semiconductor pattern SP may include silicon doped with boron (B).

The semiconductor pattern SP may be formed by epitaxially growing silicon from the bit line BL that serves as a seed pattern. As the semiconductor pattern SP is epitaxially grown from the bit line BL, a lattice direction of the bit line BL may be the same as that of the semiconductor pattern SP.

A word line WL may be provided on the substrate 100. The word line WL may overlap the growth mask layer 111 in the third direction D3. The word line WL may extend lengthwise in the second direction D2 that intersects the first direction D1. The lower gate capping pattern 112 may be interposed between the word line WL and the growth mask layer 111. The lower gate capping pattern 112 may be spaced apart from the bit line BL. The growth mask layer 111 may be interposed between the lower gate capping pattern 112 and the bit line BL.

The word line WL may include, for example, at least one selected from doped polysilicon, metal (e.g., Al, Cu, Ti, Ta, Ru, W, Mo, Pt, Ni, or Co), conductive metal nitride (e.g., TiN, TaN, WN, NbN, TiAlN, TiSiN, TaSiN, or RuTiN), conductive metal silicide, and conductive metal oxide (e.g., PtO, RuO₂, IrO₂, SRO(SrRuO₃), BSRO((Ba,Sr)RuO₃), CRO(CaRuO₃), or LSCo), but the present inventive concepts are not limited thereto. The word line WL may include a single layer or multiple layers of the materials mentioned above. In some embodiments, the word line WL may include a two-dimensional semiconductor material, such as graphene, carbon nano-tube, or any combination thereof.

The upper gate capping pattern 113 may be provided on the word line WL. The upper gate capping pattern 113 may be disposed between the word line WL and the contact pattern BC. The word line WL may be spaced apart from the contact pattern BC. The upper gate capping pattern 113 and the lower gate capping pattern 112 may include one or more of a silicon oxide layer, a silicon oxynitride layer, and a silicon nitride layer.

The gate dielectric pattern Gox may be provided on the growth mask layer 111. The gate dielectric pattern Gox may be interposed between the word line WL and the semiconductor pattern SP. The sidewall SP_SW of the semiconductor pattern SP may be in contact with the gate dielectric pattern Gox and the sidewall 111_SW of the growth mask layer 111. The gate dielectric pattern Gox may surround the semiconductor pattern SP. The gate dielectric pattern Gox may separate the word line WL from the semiconductor pattern SP. The gate dielectric pattern Gox may have a uniform thickness to cover the semiconductor pattern SP. The gate dielectric pattern Gox may be interposed between the second dielectric pattern 120 and the semiconductor pattern SP.

A sidewall of the gate dielectric pattern Gox may be in contact with the lower gate capping pattern 112, the word line WL, and the upper gate capping pattern 113. A bottom surface of the gate dielectric pattern Gox may be in contact with the top surface 11 1 TS of the growth mask layer 111.

The gate dielectric pattern Gox may include at least one selected from silicon oxide, silicon oxynitride, and high-k dielectrics whose dielectric constant is greater than that of silicon oxide. The high-k dielectric may include metal oxide or metal oxynitride. For example, the high-k dielectric that may be used as the gate dielectric pattern Gox may include at least one selected from HfO₂, HfSiO, HfSiON, HfTaO, HfTiO, HfZrO, ZrO₂, Al₂O₃, and any combination thereof, but the present inventive concepts are not limited thereto.

The first dielectric pattern 140 may be interposed between the word lines WL that neighbor each other in the first direction D1. The first dielectric pattern 140 may be interposed between the first word line WL1 and the second word line WL2. A sidewall of the first dielectric pattern 140 may be in contact with the lower gate capping pattern 112, the word line WL, and the upper gate capping pattern 113.

The second dielectric pattern 120 may be interposed between the semiconductor patterns SP that neighbor each other in the second direction D2. The second dielectric pattern 120 may be in contact with the gate dielectric pattern Gox. The second dielectric pattern 120 may be provided in plural. The plurality of second dielectric patterns 120 may extend lengthwise in the first direction D1 and may be spaced apart from each other in the second direction D2. The second dielectric pattern 120 may cover the top surface 111_TS of the growth mask layer 111. For example, the second dielectric pattern 120 may include at least one selected from silicon oxide, silicon nitride, silicon oxynitride, and low-k dielectrics. For example, the second dielectric pattern 120 may be formed of a single layer or multiple layers.

The contact pattern BC may be provided on the semiconductor pattern SP. The contact pattern BC may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or any combination thereof, but the present inventive concepts are not limited thereto. When viewed in plan, the contact pattern BC have a circular shape, an oval shape, a rectangular shape, a square shape, a rhombic shape, a hexagonal shape, or any other suitable shape.

The landing pad LP may be provided on the contact pattern BC. The landing pad LP may be in direct contact with and electrically connected to the contact pattern BC. When viewed in plan, a plurality of contact patterns BC may be spaced apart from each other in the first and second directions D 1 and D2, and may be arranged in a matrix shape, a zigzag shape, a honeycomb shape, or any other suitable shape. When viewed in plan, a plurality of landing pads LP may each have a circular shape, an oval shape, a rectangular shape, a square shape, a rhombic shape, a hexagonal shape, or any other suitable shape.

The landing pads LP may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or any combination thereof, but the present inventive concepts are not limited thereto.

A separation dielectric pattern IL may be interposed between the contact patterns BC and between the landing pads LP. The separation dielectric pattern IL may be in contact with sidewalls of the contact patterns BC and sidewalls of the landing pads LP. Upper surfaces of the separation dielectric pattern IL and the landing pads LP may be coplanar with one another.

The data storage patterns DSP may be correspondingly disposed on the landing pads LP. The data storage patterns DSP may be correspondingly electrically connected to the active regions ACT. The data storage patterns DSP may be arranged in a matrix shape along the first direction D 1 and the second direction D2. The data storage patterns DSP may completely or partially overlap the landing pads LP. The data storage patterns DSP may be in complete or partial contact with top surfaces of the landing pads LP.

According to an embodiment, the data storage patterns DSP may be capacitors, and may include bottom and top electrodes and a capacitor dielectric layer interposed between the bottom and top electrodes. Alternatively, the data storage patterns DSP may each be a variable resistance pattern that is switched from one to the other of its two resistance states by an applied electrical pulse. For example, the data storage patterns DSP may include a phase-change material whose crystalline state is changed based on an amount of current, perovskite compounds, transition metal oxide, magnetic materials, ferromagnetic materials, or antiferromagnetic materials.

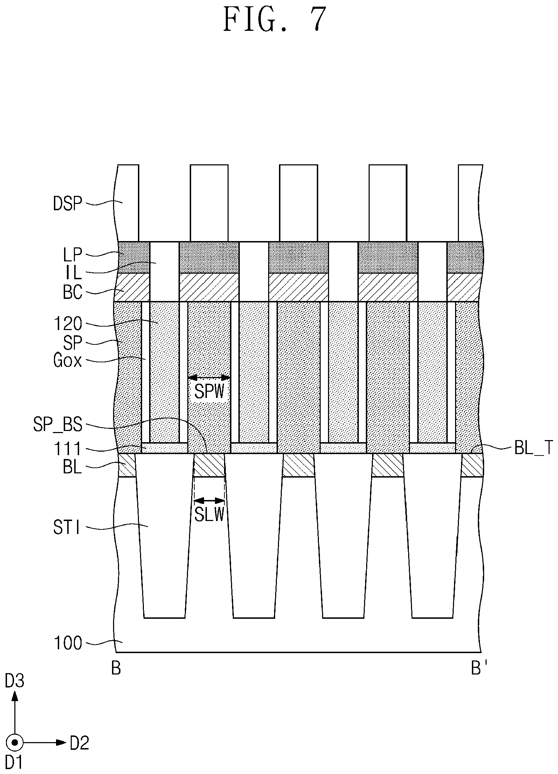

FIG. 7 illustrates a cross-sectional view taken along line B-B' of FIG. 3, showing a semiconductor device according to example embodiments of the present inventive concepts. The same description of repetitive components will not be repeated in the interest of brevity of explanation.

Referring to FIG. 7, in an embodiment, a width SPW of the semiconductor pattern SP may be different from a width SLW of the top surface BL_T of the bit line BL. The width SPW of the semiconductor pattern SP may be greater than the width SLW of the top surface BL_T of the bit line BL. While the semiconductor pattern SP is silicon epitaxially grown from the bit line BL, silicon orientation may be adjusted to achieve epitaxial growth in the third direction D3 and also in the first direction D1 or the second direction D2.

The bottom surface SP_BS of the semiconductor pattern SP may be in contact with the top surface BL_T of the bit line BL and with the top surface of the device isolation pattern S TI. In this case, the device isolation pattern STI may overlap the growth mask layer 111 and the semiconductor pattern SP.

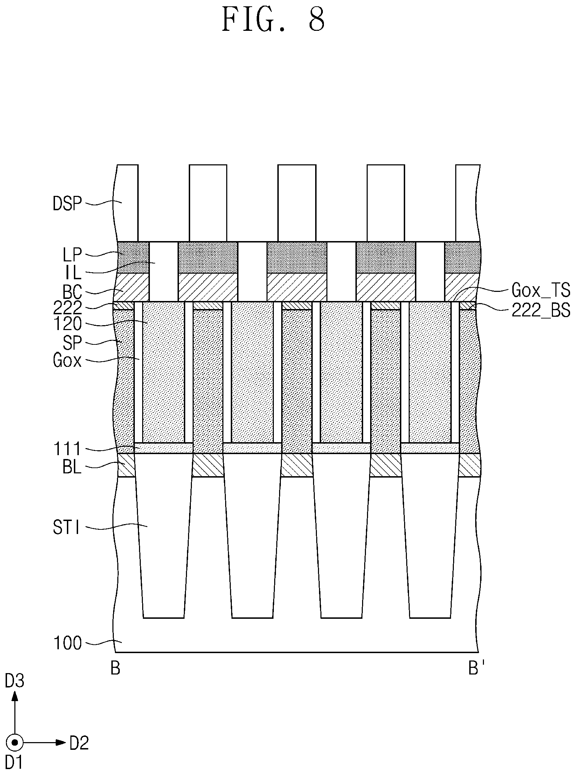

FIG. 8 illustrates a cross-sectional view taken along line B-B' of FIG. 3, showing a semiconductor device according to example embodiments of the present inventive concepts. The same description of repetitive components will be omitted in the interest of brevity of explanation.

Referring to FIG. 8, an induction capping layer 222 may be disposed on the semiconductor pattern SP. The induction capping layer 222 may overlap the bit line BL, and may not overlap the growth mask layer 111.

A top surface of the semiconductor pattern SP may be located at a different level from that of a top surface Gox_TS of the gate dielectric pattern Gox. The level of the top surface of the semiconductor pattern SP may be lower than the level of the top surface Gox_TS of the gate dielectric pattern Gox. A bottom surface 222_BS of the induction capping layer 222 may be located at a lower level than that of the top surface Gox_TS of the gate dielectric pattern Gox, and a top surface of the induction capping layer 222 may be coplanar with the top surface Gox_TS of the gate dielectric pattern Gox.

The induction capping layer 222 may include transition metal silicide. The induction capping layer 222 may include one or more of Au, Ni, Pt, and Al.

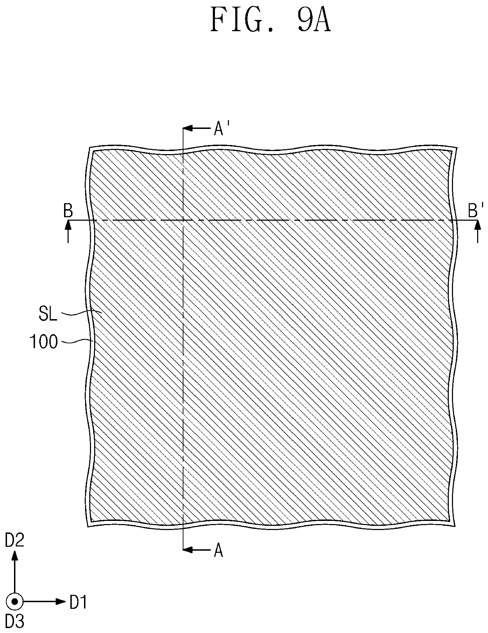

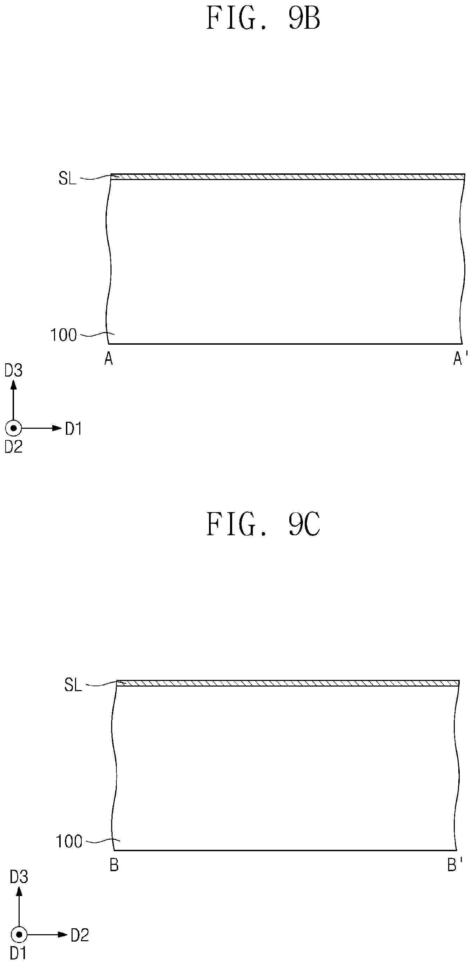

FIGS. 9A to 13A illustrate plan views showing a method of fabricating a semiconductor device according to example embodiments of the present inventive concepts. FIGS. 9B to 13B illustrate cross-sectional views taken along line A-A' of FIG. 3, showing a method of fabricating a semiconductor device according to example embodiments of the present inventive concepts. FIGS. 9C to 13C illustrate cross-sectional views taken along line B-B' of FIG. 3, showing a method of fabricating a semiconductor device according to example embodiments of the present inventive concepts.

Referring to FIGS. 3, 9A, 9B and 9C, a seed line SL may be formed on the substrate 100. The formation of the seed line SL may include, for example, depositing a phosphasilene-containing material on the substrate 100.

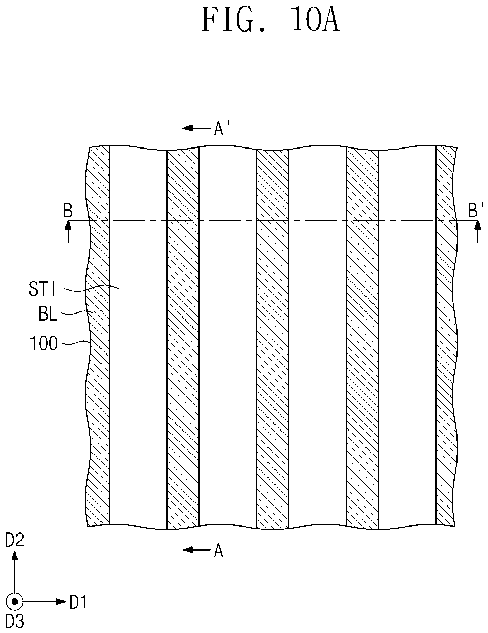

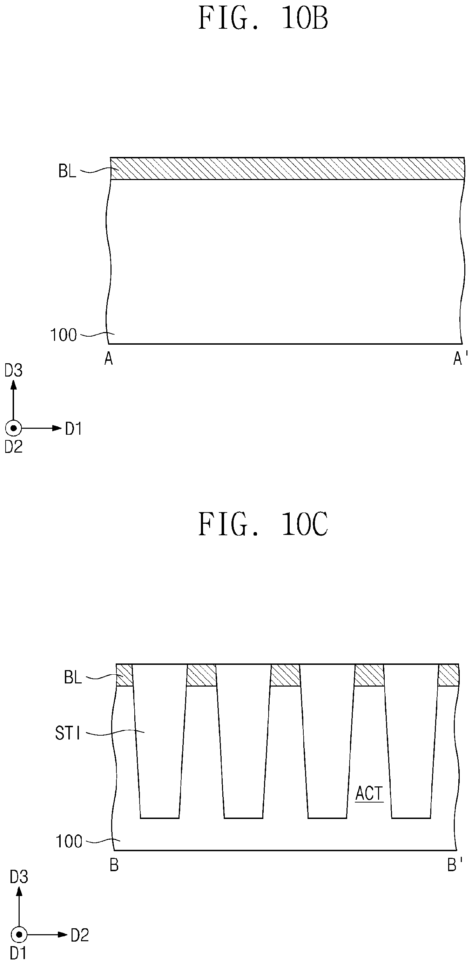

Referring to FIGS. 3, 10A, 10B, and 10C, a bit line BL may be formed on the substrate 100. A plurality of bit lines BL may be formed. The bit lines BL may be formed to extend lengthwise in a first direction D1 and to lie spaced apart from each other in a second direction D2. The bit lines BL may be formed to electrically connect with underlying lines. The formation of the bit lines BL may include epitaxially growing phosphasilene from the seed line SL that serves a seed pattern, and patterning a phosphasilene layer that is epitaxially grown. For example, the formation of the bit lines BL may include using a chemical vapor deposition method to epitaxially grow p-doped silicon. In this case, the bit lines BL may be p-doped with a concentration of about 1E20/cm³ to about 6E21/cm³.

Afterwards, a device isolation pattern STI may be formed. The formation of the device isolation pattern STI may include using a patterning process to remove an upper portion of the substrate 100 and a partial upper portion of the bit lines BL, and filling an empty region with the device isolation pattern STI.

An active region ACT may be defined to refer to regions (e.g., non-removed upper portions) of the substrate 100 that are surrounded by the device isolation pattern STI.

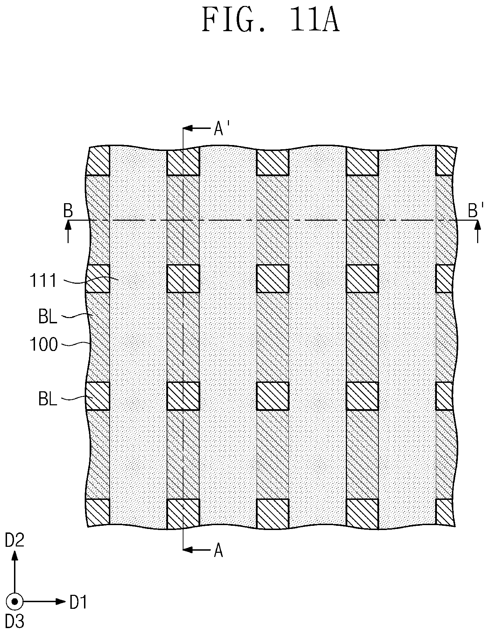

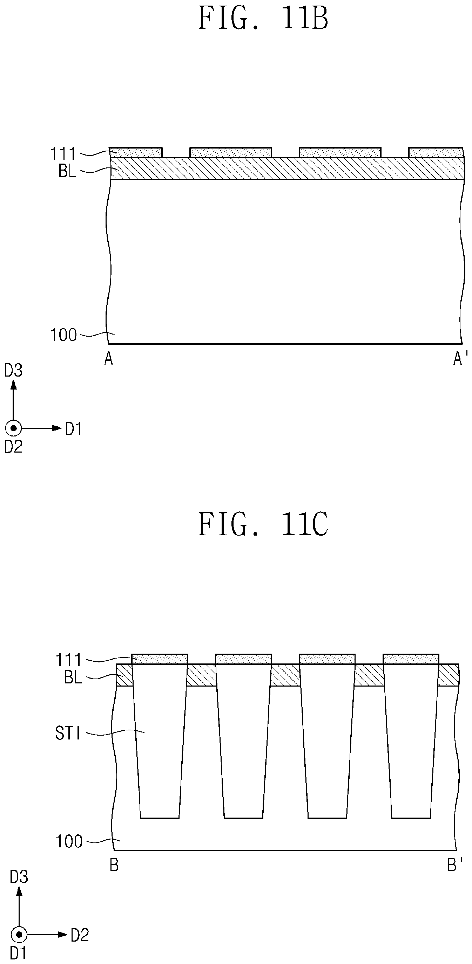

Referring to FIGS. 3, 11A, 11B, and 11C, a growth mask layer 111 may be formed on the bit lines BL. The formation of the growth mask layer 111 may include forming a preliminary growth mask layer on the device isolation pattern STI and the bit lines BL, and patterning the preliminary growth mask layer to form the growth mask layer 111 only on a section where no channel will be formed. The preliminary growth mask layer may be patterned by photolithography and etching processes.

The growth mask layer 111 may include oxide. For example, the growth mask layer 111 may include SiO₂ or Si(OC)N.

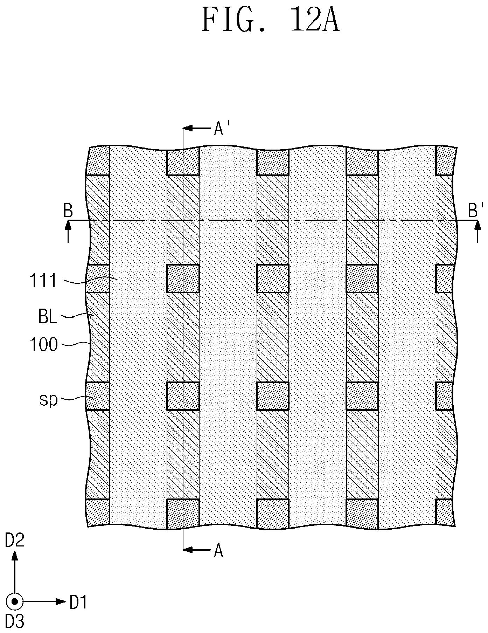

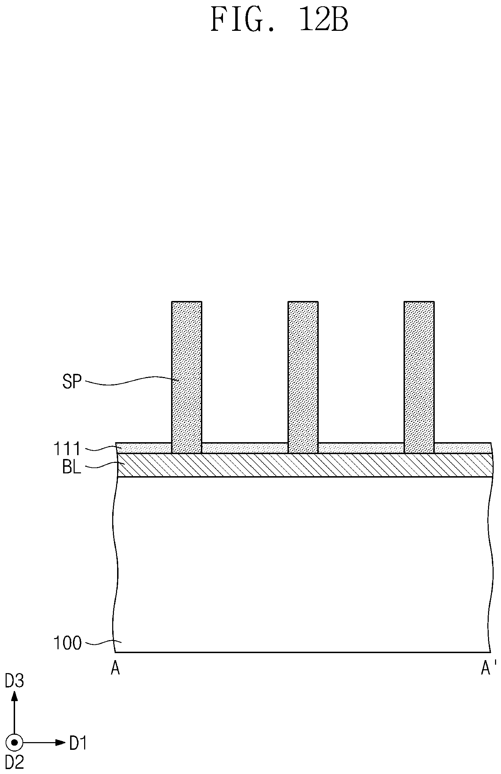

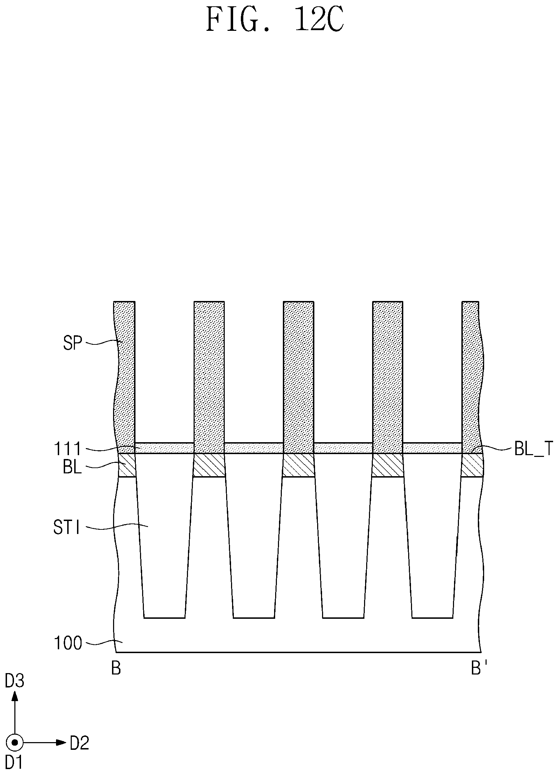

Referring to FIGS. 3, 12A, 12B, and 12C, a semiconductor pattern SP may be formed on the bit lines BL. The formation of the semiconductor pattern SP may include epitaxially growing the semiconductor pattern SP from a top surface BL_T of the bit line BL that is exposed without being overlapped with the growth mask layer 111. In this case, the semiconductor pattern SP may overlap the bit line BL, but may not overlap the growth mask layer 111. As the semiconductor pattern SP is epitaxially grown from the bit line BL, the semiconductor pattern SP and the bit line BL may have the same lattice direction.

For example, a metal catalyst may be used to form the semiconductor pattern SP. The semiconductor pattern SP may be formed by using transition metal, such as Au, Ni, Pt, or Al, as a catalyst. The formation of the semiconductor pattern SP may include introducing a precursor gas including silicon onto the bit line BL. The precursor gas may include, for example, SiH₄.

In an embodiment, the precursor gas and a doping gas (e.g., boron) may be introduced together. In this case, the semiconductor pattern SP may include doped silicon.

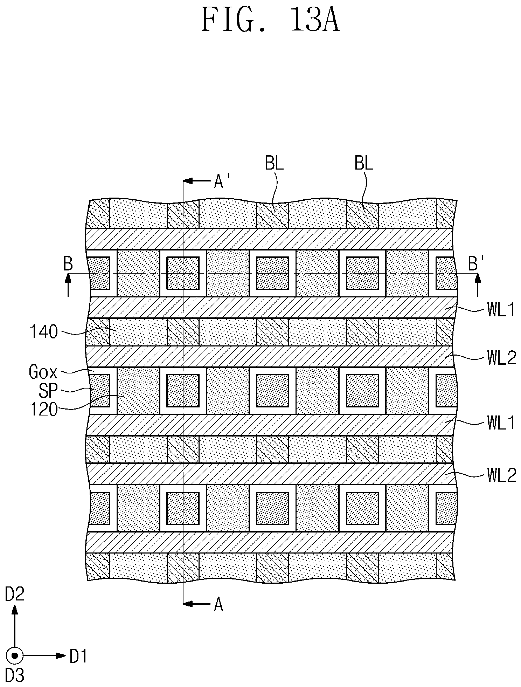

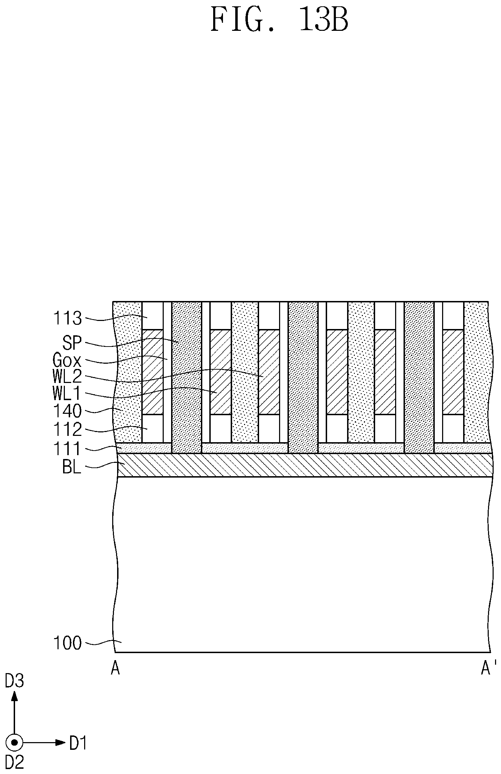

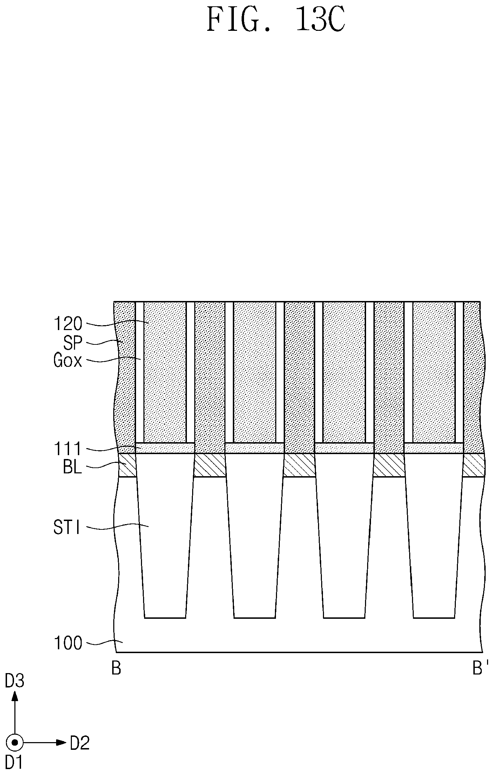

Referring to FIGS. 3, 13A, 13B, and 13C, there may be formed a gate dielectric pattern Gox, a lower gate capping pattern 112, word lines WL1 and WL2, an upper gate capping pattern 113 on the growth mask layer 111, and a first dielectric pattern 140 and a second dielectric pattern 120 may be formed.

After that, a contact pattern BC may be formed on the semiconductor pattern SP, and a landing pad LP may be formed on the contact pattern BC. A separation dielectric pattern IL may be formed to cover the contact pattern BC and the landing pad LP. A data storage pattern DSP may be formed on the landing pad LP. A semiconductor device may be fabricated as shown in FIGS. 3 to 5.

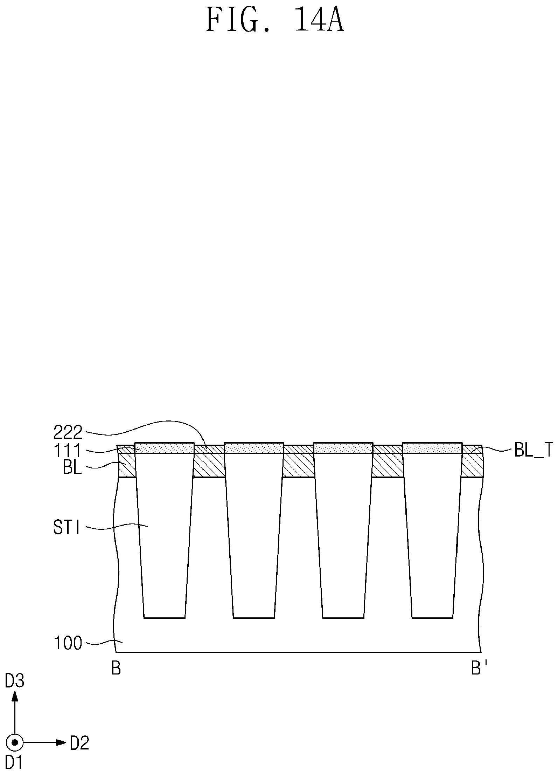

FIGS. 14A to 14C illustrate cross-sectional views showing a method of fabricating a semiconductor device according to the embodiment of FIG. 8. The same description of repetitive components will not be repeated in the interest of brevity of explanation.

Referring to FIGS. 8 and 14A, a bit line BL, a device isolation pattern STI, and a growth mask layer 111 may be formed on a substrate 100, and then an induction capping layer 222 may be formed on an exposed bit line BL. The induction capping layer 222 may include transition metal silicide. The induction capping layer 222 may include, for example, AuSi, NiSi, PtSi, or AlSi.

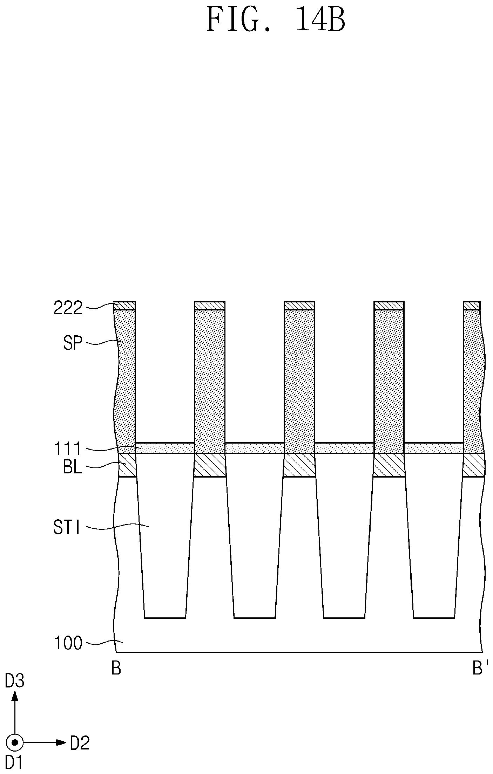

Referring to FIG. 14B, a semiconductor pattern SP may be formed on the bit line BL and below the induction capping layer 222. The formation of the semiconductor pattern SP may include allowing a precursor gas including silicon to be introduced to epitaxially grow silicon below the induction capping layer 222. When the precursor gas is introduced, a doping gas may also be introduced. In this case, the semiconductor pattern SP may include doped silicon.

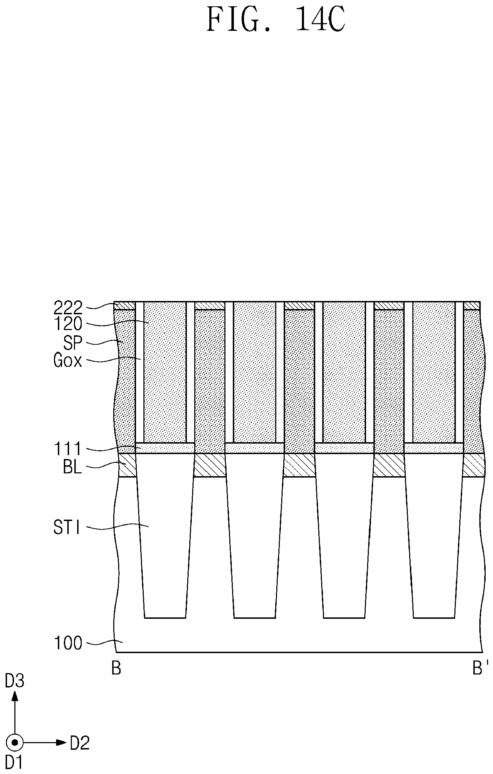

Referring to FIG. 14C, a gate dielectric pattern Gox may be formed to cover the semiconductor pattern SP and a lateral surface of the induction capping layer 222.

Thereafter, as discussed above, there may be formed a lower gate capping pattern 112, word lines WL1 and WL2, an upper gate capping pattern 113, a first dielectric pattern 140, a second dielectric pattern 120, a contact pattern BC, a landing pad LP, a separation dielectric pattern IL, and data storage patterns DSP. A semiconductor device may be fabricated as shown in FIG. 8.

According to the present inventive concepts, a semiconductor channel may be formed from a bit line that serves as a seed line while a growth mask layer is disposed on a device isolation pattern. As epitaxial growth is employed to from the semiconductor channel, a semiconductor device may be fabricated with simplicity.

Although the present inventive concepts have been described in connection with some embodiments of the present inventive concepts illustrated in the accompanying drawings, it will be understood to those skilled in the art that various changes and modifications may be made without departing from the technical spirit and essential feature of the present inventive concepts. It will be apparent to those skilled in the art that various substitution, modifications, and changes may be thereto without departing from the scope and spirit of the present inventive concepts.

## Claims

1. A semiconductor device, comprising:
a substrate that includes a device isolation pattern and an active region;
a bit line that extends in a first direction on the substrate;
a semiconductor pattern on the bit line;
a growth mask layer on the bit line, a sidewall of the growth mask layer being in contact with the semiconductor pattern;
a word line on the bit line, the word line extending in a second direction that intersects the first direction; and
a gate dielectric pattern between the word line and the semiconductor pattern,
wherein a top surface of the growth mask layer is at a level higher than a level of a bottom surface of the semiconductor pattern.

2. The semiconductor device of claim 1, wherein a lattice direction of the bit line is the same as a lattice direction of the semiconductor pattern.

3. The semiconductor device of claim 1, wherein a width in the second direction of the semiconductor pattern is greater than a width in the second direction of a top surface of the bit line.

4. The semiconductor device of claim 1,
wherein a top surface of the device isolation pattern is in contact with the growth mask layer, and
wherein the bottom surface of the semiconductor pattern is in contact with the bit line.

5. The semiconductor device of claim 1, wherein the bit line includes phosphasilene.

6. The semiconductor device of claim 1, further comprising an induction capping layer on the semiconductor pattern.

7. The semiconductor device of claim 6, wherein the induction capping layer includes one or more of Au, Ni, Pt, and Al.

8. The semiconductor device of claim 1, wherein the word line overlaps the growth mask layer.

9. A semiconductor device, comprising:
a substrate that includes a device isolation pattern and an active region;
a bit line that extends in a first direction on the substrate;
a semiconductor pattern on the bit line;
a growth mask layer on the bit line;
a word line on the bit line, the word line extending in a second direction that intersects the first direction; and
a gate dielectric pattern between the word line and the semiconductor pattern,
wherein a sidewall of the semiconductor pattern is in contact with the gate dielectric pattern and a sidewall of the growth mask layer.

10. The semiconductor device of claim 9, wherein the bit line includes phosphasilene.

11. The semiconductor device of claim 9, wherein the growth mask layer overlaps the word line and the gate dielectric pattern.

12. The semiconductor device of claim 9, wherein the growth mask layer is between the gate dielectric pattern and the bit line.

13. The semiconductor device of claim 9, wherein a width in the second direction of the semiconductor pattern is different from a width in the second direction of a top surface of the bit line.

14. The semiconductor device of claim 9, wherein a top surface of the growth mask layer and a bottom surface of the gate dielectric pattern are at substantially the same height.

15. The semiconductor device of claim 9, further comprising an induction capping layer on the semiconductor pattern,
wherein a bottom surface of the induction capping layer is at a level lower than a level of a top surface of the gate dielectric pattern.
